(19) Europäisches Patentamt European Patent Office Office européen des brevets

(11) **EP 4 206 131 A1**

(12) **EUROPEAN PATENT APPLICATION**
published in accordance with Art. 153(4) EPC

(43) Date of publication:
**05.07.2023 Bulletin 2023/27**

(21) Application number: **21861305.7**

(22) Date of filing: **17.08.2021**

(51) International Patent Classification (IPC):
$C01B\ 33/18^{(2006.01)}$ $H01L\ 23/29^{(2006.01)}$
$H01L\ 23/31^{(2006.01)}$ $C08L\ 63/00^{(2006.01)}$
$C08K\ 3/36^{(2006.01)}$

(52) Cooperative Patent Classification (CPC):
**C01B 33/18; C08G 59/00; C08K 3/36; C08L 63/00;
H01L 23/29; H01L 23/31;** Y02E 30/30

(86) International application number:
**PCT/JP2021/029999**

(87) International publication number:
**WO 2022/044877 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.08.2020 JP 2020141931**

(71) Applicant: **Denka Company Limited
Tokyo 103-8338 (JP)**

(72) Inventors:
• **HATAYAMA, Yasuaki
Tokyo 103-8338 (JP)**
• **FUKUDA, Takashi
Tokyo 103-8338 (JP)**
• **SUGIMOTO, Atsuya
Tokyo 103-8338 (JP)**

(74) Representative: **Gulde & Partner
Patent- und Rechtsanwaltskanzlei mbB
Wallstraße 58/59
10179 Berlin (DE)**

(54) **AMORPHOUS SILICA POWDER AND RESIN COMPOSITION**

(57) The present invention provides an amorphous silica powder that is suitable for obtaining a solid sealant that exhibits superior fluidity and filling properties, and a resin composition obtained by using the amorphous silica powder as a filler. More specifically, in the present invention, an amorphous silica powder is prepared so as to have a modal diameter within the range of 1 to 10 $\mu$m in the particle diameter frequency distribution and have a frequency of particles having particle diameters of 0.50 to 1.83 $\mu$m of less than 3.0% in the particle diameter frequency distribution.

EP 4 206 131 A1

**Description**

Technical Field

The present invention relates to an amorphous silica powder suitable for a solid sealant and a resin composition containing the amorphous silica powder.

Background Art

In general, a semiconductor device in which a semiconductor chip mounted on a board is sealed with a resin is well known. A flip-chip connection method is known as a technique for addressing a demand for further reduction in size and thickness and increase in density of such a semiconductor device.

A technique related to a flip-chip connection method is disclosed in Patent Document 1. In the case of this flip-chip connection method, since two steps of underfilling of narrow gaps and overmolding of the entire chip are required, a technique (solid sealing technique) for collectively performing filling of the narrow gaps under the chip and sealing of the entire chip with only a non-liquid epoxy resin composition has been developed. In this development, the fluidity of the resin composition is a problem (Patent Document 2).

Prior Art Documents

Patent Documents

Patent Document 1: JP 3695521 B2
Patent Document 2: JP 2011-132268 A

Disclosure of Invention

Problems to be Solved by the Invention

The present invention provides an amorphous silica powder that is suitable for solid sealing and exhibits superior fluidity and a resin composition containing the amorphous silica powder.

Means for Solving the Problems

The present inventors have succeeded in solving the above problems by achieving a modal diameter within the range of 1 to 10 $\mu$m in the particle diameter frequency distribution and a frequency of particles having particle diameters of 0.50 to 1.83 $\mu$m of less than 3.0% in the particle diameter frequency distribution.

That is, an aspect of the present invention provides an amorphous silica powder having a modal diameter within the range of 1 to 10 $\mu$m in the particle diameter frequency distribution and having a frequency of particles having particle diameters of 0.50 to 1.83 $\mu$m of less than 3.0% in the particle diameter frequency distribution.

The amorphous silica powder of the present invention has a specific surface area of 1 to 12 $m^2$/g. The specific surface area is preferably 3 to 10.5 $m^2$/g.

In the amorphous silica powder of the present invention, the cumulative oversize distribution of particles having particle diameters of 13 um or more is 1 mass% or less.

Furthermore, the amorphous silica powder of the present invention has a melting rate of 95% or more, and the total concentration of the uranium element and the thorium element is 10 ppb or less.

Another aspect of the present invention also provides a resin composition for solid sealing containing the amorphous silica powder of the present invention, an epoxy resin, a curing agent, and a curing accelerator.

The resin composition of the present invention contains 80 to 90 mass% of the amorphous silica powder.

Effects of the Invention

The resin composition containing the amorphous silica powder of the present invention is particularly useful as a semiconductor sealing agent because it exhibits superior flow characteristics such as spiral flow and narrow gap filling properties.

Mode for Carrying Out the Invention

Hereinafter, the present invention will be described in more detail. Note that the present invention is not limited to the following embodiment.

<Amorphous Silica Powder>

The fluidity of an amorphous silica powder of the present invention can be improved by adjusting the modal diameter to the range of 1 to 10 $\mu$m in the particle diameter frequency distribution and adjusting the frequency of particles having particle diameters of 0.50 to 1.83 $\mu$m to less than 3.0% in the particle diameter frequency distribution.

In the particle diameter frequency distribution of the amorphous silica powder of the present invention, the modal diameter is within the range of 1 to 10 um. When the modal diameter in the particle diameter frequency distribution of the amorphous silica powder exceeds 10 $\mu$m, the above problem occurs. On the other hand, in the case of a powder having a small particle diameter as represented by a modal diameter in the particle diameter frequency distribution of less than 1 $\mu$m, the viscosity of a semiconductor sealant becomes too high, and the amount of the powder to be filled cannot be increased. The lower limit may be 1.5 um or more, 2.0 um or more, 2.5 um or more, 3.0 um or more, or 3.2 um or more. The upper limit may be 8.0 $\mu$m or less, 7.0 $\mu$m or less, 6.0 $\mu$m or less, 5.0 $\mu$m or less, 4.2 um or less, or 4.0 $\mu$m or less. In the particle diameter frequency distribution of the amorphous silica powder of the present invention, for example, the modal diameter is within the range of 3.0 to 4.2 um. The modal diameter referred to herein is a particle diameter that exhibits the highest frequency in a particle diameter distribution obtained by a measurement method described later of a powder. In the case where the modal diameter of an amorphous silica powder as a raw material exceeds 10 um, classification is performed to adjust the particle diameter distribution.

In addition, when the frequency of particles having particle diameters of 0.50 to 1.83 um is less than 3.0 vol% in a peak having a maximum value within the range of 1 to 10 um, the fluidity of the amorphous silica powder can be further enhanced. The frequency is more preferably 2.5% or less, 2.0% or less, 1.5% or less, 1.0% or less, or 0.5% or less or may be 0.0%. As a method for adjusting the frequency of particles having particle diameters of 0.50 to 1.83 um to less than 3.0%, a conventionally known method can be adopted, and for example, a method of removing the coarse powder side and the fine powder side using a precision air classifier can be exemplified. The frequency of particles having particle diameters of 0.50 to 1.83 um is a value obtained by a method for measuring a particle size distribution described later.

The number of frequency maximum peaks within the range of 1 to 10 um in the particle diameter frequency distribution may be 1 from the viewpoint of obtaining the effect of the present invention, or there may be a plurality of peaks.

The frequency at the maximum value of the peak of the modal diameter showing the frequency maximum within the range of 1 to 10 um in the particle diameter frequency distribution may be 5 vol% or more. The lower limit of the frequency may be 9 vol% or more. The upper limit of the frequency may be 20 vol% or less, 15 vol% or less, or 14.5 vol% or less.

The specific surface area is preferably 1 to 12 m$^2$/g. In particular, in the present invention, since the frequency of particles having particle diameters of 0.50 to 1.83 $\mu$m is less than 3.0%, the specific surface area tends to decrease. Therefore, it is preferable to add an ultrafine powder of 0.5 $\mu$m or less to increase the specific surface area. A preferred size of the ultrafine powder is 0.1 to 0.5 $\mu$m in median diameter. In the case where the specific surface area of the amorphous silica powder exceeds 12 m$^2$/g, the tendency of aggregation between fine particles increases, and the fluidity of the semiconductor sealant decreases. The upper limit may be 10.5 m$^2$/g or less, 9 m$^2$/g or less, or 8 m$^2$/g or less. On the other hand, in the case where the specific surface area is less than 1 m$^2$/g, the powder is less likely to form a closest packed structure, so that the fluidity of the semiconductor sealant is reduced. The specific surface area is more preferably 2 m$^2$/g or more, still more preferably 3 m$^2$/g or more.

In the amorphous silica powder of the present invention, d10, d50, and d90 are not particularly limited. The value of d10 may be 0.5 to 4.0 $\mu$m. The value of d50 may be 3.5 to 7.0 $\mu$m. The value of d90 may be 4.0 to 9.0 $\mu$m. However, d10 is preferably 1.5 to 3.5 $\mu$m from the viewpoint of obtaining the effect of the present invention. The value of d50 is preferably 3.0 to 5.0 $\mu$m. The value of d90 is preferably 4.0 to 7.0 $\mu$m. Here, d10, d50, and d90 are the particle diameters at the cumulative values of 10%, 50%, and 90% in the particle diameter cumulative distribution, respectively. For the amorphous silica powder, the particle diameter distribution is obtained by a method to be described later and is represented by a volume distribution, and the refractive index is set to 1.5.

In the amorphous silica powder of the present invention, the cumulative oversize distribution of particles having particle diameters of 13 um or more is 1 mass% or less and can be 0 mass%. Since the number of coarse particles is small, the amorphous silica powder can more easily form a closest packed structure, and the fluidity of the semiconductor sealant is improved.

The amorphous silica powder of the present invention may contain other components (additives and the like) other than the amorphous silica powder as long as the effect of the present invention is not impaired. For example, the other components may be 5 mass% or less, 3 mass% or less, 1 mass% or less, or 0 mass%.

In addition, it is preferable that the amorphous silica powder of the present invention do not contain the uranium element or the thorium element as other components depending on the application. In the case of use in a semiconductor sealant for sealing a semiconductor, the total concentration of the uranium element and the thorium element is preferably 10 ppb or less from the viewpoint of reducing the failure occurrence rate of memory rewriting.

The amorphous silica powder of the present invention is optimally an amorphous silica powder produced by melting crystalline silica at a high temperature or synthesis in terms of bringing the thermal expansion coefficients of the semiconductor chip and the semiconductor sealant close to each other. Therefore, the melting rate of the amorphous silica powder of the present invention is preferably 95% or more.

The shape of the amorphous silica powder may be any of a spherical shape, a crushed shape, a needle shape, a flake shape, and the like, but a spherical amorphous silica powder is preferable from the viewpoint of filling the powder as much as possible to reduce the thermal expansion coefficient of the semiconductor sealant.

The amorphous silica powder of the present invention may be used in the form of a mixture with another inorganic filler. Here, the other inorganic filler includes a different type of filler such as alumina powder and magnesia powder, and an amorphous silica powder having a different particle size distribution.

The particle diameter distribution of the amorphous silica powder of the present invention is measured using Coulter Particle Size Analyzer LS 13 320 (Coulter Beckman, Inc.). For the measurement conditions, a silica aqueous solution subjected to dispersing in advance with an ultrasonic homogenizer is put into the device, and analysis is performed under the condition of a refractive index of 1.5.

The production of the amorphous silica powder of the present invention can be carried out by mixing appropriate amounts of powders with different particle size compositions or by classification. From an industrial point of view, classification by a classifier is desirable, and the classification operation may be performed by either a dry method or a wet method. From the viewpoint of productivity and removal of coarse particles, it is preferable to use a dry precision air classifier.

<Resin Composition>

Next, the resin composition of the present invention will be described.

The improvement of the fluidity of the invention of the present application is considered to be achieved because the interaction between the particles is adjusted by adjusting the particle size distribution. Therefore, the effect of improving the fluidity can be obtained regardless of the type of the resin. Therefore, it can be used for improving the fluidity of not only the resin composition for solid sealing but also the resin composition for liquid sealing. However, since the amorphous silica powder of the present invention is suitable for solid sealing, a resin for solid sealing will be described below. The non-liquid resin composition to be used for solid sealing is, for example, a resin composition in a solid state at normal temperature, such as a powdery form, a granular form, or a compressed tablet form.

The resin composition for solid sealing contains a resin, a curing agent, an inorganic filler, and a curing accelerator. Each component will be described below.

For solid sealing, an epoxy resin is preferably used as the resin. As the epoxy resin, an epoxy resin conventionally used in the technical field of an epoxy resin composition for sealing can be used without particular limitation. Examples of such an epoxy resin include a phenol novolac epoxy resin, a cresol novolac epoxy resin, a bisphenol epoxy resin, a stilbene epoxy resin, a triphenol methane epoxy resin, a phenol aralkyl epoxy resin, a naphthol epoxy resin, a naphthalene epoxy resin, a biphenyl epoxy resin, a dicyclopentadiene epoxy resin, a phenylene epoxy resin, and a triphenylmethane epoxy resin. These may be used singly or in combination of two or more kinds thereof.

The content of the epoxy resin in the resin composition may be 2 to 15 mass%.

As the curing agent, a curing agent conventionally used in the technical field of an epoxy resin composition for sealing can be used without particular limitation. Examples of such a curing agent include various polyhydric phenol compounds or naphthol compounds, such as a phenol novolac resin, a cresol novolac resin, a phenol aralkyl resin, a naphthol aralkyl resin, and a biphenyl aralkyl resin. These may be used singly or in combination of two or more kinds thereof.

The blending ratio of the epoxy resin and the curing agent (epoxy resin/curing agent) is preferably 0.5 to 1.5, more preferably 0.8 to 1.2, in terms of equivalent ratio. If this blending ratio is excessively small, the curing agent becomes excessive, which is economically disadvantageous, and if this blending ratio is excessively large, the amount of the curing agent becomes excessively small, and insufficient curing occurs.

As the curing accelerator, a curing accelerator conventionally used in the technical field of an epoxy resin composition for sealing can be used without particular limitation. Examples of such a curing accelerator include imidazoles such as 2-methylimidazole, 2-ethyl-4-methylimidazole, 2-methyl-4-ethylimidazole, 2-phenylimidazole, and 2-methyl-4-methylimidazole; tertiary amines such as 1,8-diazabicyclo[5.4.0]undecene-7, triethylenediamine, and benzyldimethylamine; organic phosphines such as triphenylphosphine, tributylphosphine, and tetraphenylphosphonium tetraphenylborate; and microencapsulated products thereof. These may be used singly or in combination of two or more kinds thereof.

The content of the curing accelerator is preferably 1 to 10 parts by mass or less with respect to 100 parts by mass of the total content of the epoxy resin and the curing agent. When the content of the curing accelerator is less than 1 part by mass, the curing accelerating function is not well exhibited, and when the content of the curing accelerator is more than 10 parts by mass, moldability may be impaired. The content is preferably 2 to 4 parts by mass.

The amorphous silica powder of the present invention is used as the inorganic filler. The content thereof is preferably 80 to 90 mass%, more preferably 83 to 90 mass%, still more preferably 86 to 90 mass%.

In addition, the resin composition of the present invention may further contain other additives such as a coupling agent, a mold release agent, a colorant, a flame retardant, an ion trapping agent, and a flexible agent as other components. Examples of the coupling agent that can be used in the present embodiment include aminosilanes such as γ-aminopropyltriethoxysilane and N-phenyl-γ-aminopropyltrimethoxysilane; mercaptosilanes such as mercaptopropyltrimethoxysilane; and glycidoxysilanes such as γ-glycidoxypropyltrimethoxysilane and γ-glycidoxypropyltriethoxysilane, and these may be used singly or in combination of two or more thereof. Examples of the release agent that can be used in the present embodiment include waxes having high melting points such as carnauba wax and montan wax, higher fatty acids such as stearic acid and salts and esters thereof, and carboxy group-containing polyolefins, and these may be used singly or in combination of two or more thereof. Examples of the colorant that can be used in the present embodiment include carbon black and various pigments. The flame retardant that can be used in the present embodiment is preferably a halogen-free or antimony-free flame retardant, and examples thereof include metal hydroxides (metal hydrates) such as magnesium hydroxide, aluminum hydroxide, and calcium hydroxide. The content of these other additives in the epoxy resin composition may be appropriately determined within a range in which the function of each additive is well exhibited, and the content is, for example, within the range of 0.01 to 5 mass% with respect to the total amount of the epoxy resin composition. The total amount of these other components and impurities may be 10 mass% or less, 8 mass% or less, 5 mass% or less, or 3 mass% or less.

The non-liquid epoxy resin composition is prepared, for example, as follows. That is, an epoxy resin, a curing agent, an inorganic filler, a curing accelerator, and other components are blended in predetermined amounts, respectively, uniformly mixed with a mixer, a blender, or the like, and then heated and kneaded with a kneader, a roll, or the like. After kneading, the mixture is cooled and solidified, and pulverized to a predetermined particle size to provide a powdery or granular epoxy resin composition that is in a solid state at normal temperature. If necessary, it may be formed into a tablet shape by further tableting.

Hereinafter, a method for using the resin composition for solid sealing of the present invention will be described.

In the present embodiment, a semiconductor device (not employing a flip-chip connection method) is produced, for example, as follows. That is, a semiconductor chip is mounted on a semiconductor chip mounting board, the board and the semiconductor chip are electrically connected (wire-bonded) with a gold wire, and then the semiconductor chip on the board is sealed with the resin composition of the present invention. To perform this sealing, transfer molding using a mold can be employed.

In the present embodiment, a semiconductor device employing a flip-chip connection method is produced, for example, as follows. That is, a projecting electrode (bump) is formed on a circuit surface of a semiconductor chip and directly connected to an electrode terminal of a semiconductor chip mounting board by face-down mounting, and then the semiconductor chip on the board is collectively sealed with the resin composition of the present invention. That is, mold underfilling is performed in which filling of the narrow gap under the chip and sealing of the entire chip are collectively performed. To perform this collective sealing, transfer molding using a mold can be employed.

Examples

<Preparation of Amorphous Silica Powder>

Amorphous silica powders of preparation examples of the present invention were prepared by the following procedure. As a raw material, commercially available amorphous silica was used. This raw material had one peak of the modal diameter in the range of 1 to 10 μm.

[Coarse Powder Classification]

In this example, the raw material amorphous silica powder was subjected to coarse powder classification in order to exclude large particle diameters. The cumulative oversize distribution of particles having particle diameters of 13 um or more is shown in Table 2. In the examples, the cumulative oversize distribution of particles having particle diameters of 13 um or more was 0.0 mass%.

[Fine Powder Classification]

Next, the cumulative value of particles having particle diameters of 0.50 to 1.83 um was adjusted by a method of removing the fine powder side using a precision air classifier. Table 2 shows the cumulative value of particles having particle diameters of 0.50 to 1.83 um. In the examples, the frequency at the modal diameter within the range of 1 to 10 um was 9.3 to 14.3 vol%.

[Blending of Ultrafine Powder]

Next, an amorphous silica powder having a small particle diameter (ultrafine powder having a median diameter of 0.19, 0.28, or 0.37 $\mu$m) was blended with the amorphous silica powder obtained in the steps up to fine powder classification at an internal addition ratio shown in Table 2.

<Preparation of Resin Composition>

An epoxy resin, a curing agent, an inorganic filler, a curing accelerator, and other materials were mixed at a composition (mass%) shown in Table 1, homogenized, then heated and kneaded with a biaxial roll heated to 80°C, extruded, cooled and solidified, and then pulverized to a predetermined particle size with a pulverizer to prepare a powdery epoxy resin composition in a solid state at normal temperature.

[Table 1]

| Product name | Manufacturer | Blending ratio (wt%) | Content |
|---|---|---|---|
| YH-4000HK | Mitsubishi Chemical Corporation | 7.3 | Epoxy resin (main material) |
| MEHC-7800-4S | Meiwa Plastic Industries, Ltd. | 6.8 | Phenol resin (curing material) |
| KBM-403 | Shin-Etsu Chemical Co., Ltd. | 0.35 | Silane coupling material ($\gamma$-glycidoxypropyltrimethoxysilane) |
| TPP | Hokko Chemical Industry Co., Ltd. | 0.2 | Catalyst (triphenylphosphine) |
| Lico-WAX E | Clariant Chemicals KK | 0.3 | Ester wax |
| Spherical silica | | 85.0 | Amorphous silica powder prepared above |
| Total | | 100.0 | |

<Evaluation of Amorphous Silica Powder and Resin Composition>

The characteristic values of the obtained amorphous silica powder and resin composition were measured according to the following. The measurement methods are as follows.

[Evaluation of Amorphous Silica Particles]

(1) Specific Surface Area

The BET theory was applied to the adsorption isotherm measured by the gas adsorption method to determine the specific surface area (BET value) (BET method).

(2) Particle Diameter

The particle diameter frequency distribution and the particle diameter cumulative distribution of the fine powder were measured using the Coulter method, which is not affected by the sample density.
The median diameter d ($\mu$m) of the ultrafine powder was determined from the BET value measured using the BET method by the following formula for silica particles (density 2.2 g/cm$^3$).

[Mathematical Formula 1]

Median diameter d = 6/((BET value)*2.2)

(3) Melting Rate

The melting rate in the present invention can be measured from the intensity ratio of a specific diffraction peak by performing X-ray diffraction analysis of a sample with the CuKα line at 20 within the range of 26° to 27.5° using a powder X-ray diffractometer. That is, although crystalline silica has a main peak at 26.7°, fused silica does not have a main peak at this position. When fused silica and crystalline silica are mixed, a peak height at 26.7° corresponding to the ratio between the fused silica and the crystalline silica is obtained. Therefore, the mixing ratio of the crystalline silica (X-ray intensity of sample/X-ray intensity of crystalline silica) is calculated from the ratio of the X-ray intensity of the sample to the X-ray intensity of the crystalline silica standard sample, and the melting rate can be determined by the following formula.

[Mathematical Formula 2]

Melting rate (%) = (1 - mixing ratio of crystalline silica)

× 100

(4) Concentration of Uranium Element and Thorium Element

The content of the uranium element and the thorium element was measured using an inductively coupled plasma mass spectrometer (ICP-MS), and the concentration in the powder was calculated.

[Evaluation of Resin Composition]

Using the prepared powdery epoxy resin composition, transfer molding was performed under the following conditions to evaluate spiral flow and narrow gap filling properties.

(5) Spiral Flow

(Conditions)

· Mold size: Spiral shape of φ3 mm
· Mold temperature: 175°C
· Injection pressure: 65 kgf/cm$^2$
· Molding time: 90 seconds

(6) Narrow Gap Filling Properties

(Conditions)

· Mold size: 5 × 60 × 0.02 mm
· Mold temperature: 175°C
· Injection pressure: 65 kgf/cm$^2$
· Molding time: 90 seconds

[Evaluation Results]

Table 2 shows preparation conditions (powder classification conditions and composition) of each amorphous silica powder, powder characteristics, and physical property values of flow characteristics (spiral flow and narrow gap filling properties) of a resin composition using each amorphous silica powder.

[Table 2]

| | Example 1 | Example 2 | Example 3 | Example 4 | Example 5 | Example 6 | Example 7 | Example 8 | Example 9 | Example 10 | Example 11 | Comparative Example 1 | Comparative Example 2 |
|---|---|---|---|---|---|---|---|---|---|---|---|---|---|
| Coarse powder classification | ○ | ○ | ○ | ○ | ○ | ○ | ○ | ○ | ○ | ○ | ○ | ○ | ○ |
| Fine powder classification | ○ | ○ | ○ | ○ | ○ | ○ | ○ | - | ○ | - | ○ | - | - |
| Average particle diameter of ultrafine powder ($\mu$m) | 0.14 | 0.45 | 0.14 | 0.10 | 0.14 | 0.10 | 0.10 | 0.14 | - | 0.10 | 0.10 | 0.10 | - |
| Internal addition ratio of ultrafine powder (%) | 28 | 24 | 28 | 28 | 19 | 37 | 19 | 15 | 0 | 19 | 0 | 37 | 0 |
| Specific surface area (m$^2$/g) | 5.9 | 3.3 | 6.1 | 7.5 | 4.2 | 10.1 | 5.0 | 4.9 | 2.4 | 6.1 | 8.1 | 9.9 | 4.7 |
| Melting rate (%) | 100.0 | 100.0 | 99.9 | 100.0 | 99.7 | 98.3 | 99.8 | 100.0 | 99.5 | 100.0 | 99.9 | 96.0 | 99.0 |
| Concentration of uranium + thorium (ppb) | 7.6 | 31.2 | 6.9 | 9.4 | 2.6 | 1.7 | 1.8 | 4.1 | 0.9 | 4.8 | 8.6 | 9.4 | 15.0 |
| Modal diameter ($\mu$m) | 3.9 | 3.4 | 3.9 | 3.9 | 3.9 | 3.5 | 3.9 | 3.2 | 3.5 | 3.2 | 3.2 | 3.2 | 3.9 |
| Frequency at maximum of peak of modal diameter (%) | 11.9 | 14.3 | 9.3 | 12.5 | 12.7 | 11.3 | 12.2 | 13.6 | 12.1 | 13.6 | 13.0 | 12.0 | 9.0 |
| Frequency of particles | 0.0 | 0.0 | 0.3 | 0.0 | 0.0 | 0.0 | 0.0 | 1.0 | 0.1 | 2.0 | 2.4 | 4.7 | 6.7 |

EP 4 206 131 A1

| | Example 1 | Example 2 | Example 3 | Example 4 | Example 5 | Example 6 | Example 7 | Example 8 | Example 9 | Example 10 | Example 11 | Comparative Example 1 | Comparative Example 2 |
|---|---|---|---|---|---|---|---|---|---|---|---|---|---|
| having particle diameters of 0.50 to 1.83 $\mu$m (%) | | | | | | | | | | | | | |
| Cumulative oversize distribution of particles having particle diameters of 13 $\mu$m or more (mass%) | 0.0 | 0.0 | 0.0 | 0.0 | 0.0 | 0.0 | 0.0 | 0.0 | 0.0 | 0.0 | 0.0 | 0.0 | 0.0 |
| Spiral flow (cm) | 105 | 104 | 98 | 91 | 88 | 77 | 74 | 68 | 66 | 65 | 63 | 57 | 51 |
| Narrow gap filling property (cm) | 52 | 55 | 55 | 49 | 48 | 42 | 51 | 41 | 41 | 42 | 43 | 38 | 32 |

Industrial Applicability

The resin composition containing the amorphous silica powder of the present invention having a modal diameter within the range of 1 to 10 $\mu$m in the particle diameter frequency distribution and having a frequency of particles having particle diameters of 0.50 to 1.83 $\mu$m of less than 3.0% in the particle diameter frequency distribution as a filler exhibits superior fluidity and filling properties and is therefore suitable for a sealing agent for a semiconductor device.

**Claims**

1. An amorphous silica powder having a modal diameter within a range of 1 to 10 $\mu$m in a particle diameter frequency distribution and having a frequency of particles having particle diameters of 0.50 to 1.83 $\mu$m of less than 3.0% in the particle diameter frequency distribution.

2. The amorphous silica powder according to claim 1, having a specific surface area of 1 to 12 $m^2$/g.

3. The amorphous silica powder according to claim 1 or 2, wherein a cumulative oversize distribution of particles having particle diameters of 13 um or more is 1 mass% or less.

4. The amorphous silica powder according to any one of claims 1 to 3, wherein a melting rate is 95% or more.

5. The amorphous silica powder according to any one of claims 1 to 4, wherein a total concentration of a uranium element and a thorium element is 10 ppb or less.

## INTERNATIONAL SEARCH REPORT

International application No.

**PCT/JP2021/029999**

### A. CLASSIFICATION OF SUBJECT MATTER

*C01B 33/18*(2006.01)i; *H01L 23/29*(2006.01)n; *H01L 23/31*(2006.01)n; *C08L 63/00*(2006.01)n; *C08K 3/36*(2006.01)n
FI:   C01B33/18 E; C08K3/36; H01L23/30 R; C08L63/00 C

According to International Patent Classification (IPC) or to both national classification and IPC

### B. FIELDS SEARCHED

Minimum documentation searched (classification system followed by classification symbols)

C01B33/18; H01L23/29; H01L23/31; C08L63/00; C08K3/36

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

JSTPlus/JST7580 (JDreamIII)

### C. DOCUMENTS CONSIDERED TO BE RELEVANT

| Category* | Citation of document, with indication, where appropriate, of the relevant passages | Relevant to claim No. |
|---|---|---|
| X | CN 104556076 A (SUZHOU NADI MICROELECTRONICS CO., LTD.) 29 April 2015 (2015-04-29)<br>      paragraphs [0001], [0020], [0021], fig. 1 | 1, 3-5 |
| A | | 2 |
| X | CN 110950345 A (SUZHOU NADI MICROELECTRONICS CO., LTD.) 03 April 2020 (2020-04-03)<br>      paragraphs [0021], [0029]-[0037], fig. 1, 2 | 1, 2, 4, 5 |
| X | JP 5-193927 A (MIZUSAWA IND CHEM LTD) 03 August 1993 (1993-08-03)<br>      paragraphs [0001], [0034]-[0038], Brief Description of the Drawings, fig. 2 | 1, 3, 4 |
| X | JP 2006-298708 A (DENKI KAGAKU KOGYO KK) 02 November 2006 (2006-11-02)<br>      paragraph [0023], [0024] | 1, 4 |

☐ Further documents are listed in the continuation of Box C.       ☑ See patent family annex.

| | |
|---|---|
| *     Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **06 October 2021** | **19 October 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2021/029999**

| Patent document cited in search report | | | Publication date (day/month/year) | Patent family member(s) | Publication date (day/month/year) |
|---|---|---|---|---|---|
| CN | 104556076 | A | 29 April 2015 | (Family: none) | |
| CN | 110950345 | A | 03 April 2020 | (Family: none) | |
| JP | 5-193927 | A | 03 August 1993 | US 5342876 A<br>column 1, lines 7-18, column 8, lines 61-63, column 15, line 48 to column 18, line 5, fig. 2<br>GB 2263903 A<br>DE 4301945 A1<br>KR 10-1993-0016344 A | |
| JP | 2006-298708 | A | 02 November 2006 | (Family: none) | |

Form PCT/ISA/210 (patent family annex) (January 2015)

**REFERENCES CITED IN THE DESCRIPTION**

**Patent documents cited in the description**

- JP 3695521 B

- JP 2011132268 A